# EUROPEAN PATENT APPLICATION

(11) **EP 4 812 003 A2**
(43) Date of publication of application: **23.09.2026**
(21) Application number: 25219711.6
(22) Date of filing: 01.12.2025
(51) Int. Cl.: H10P 72/30

(54) **SUBSTRATE PROCESSING APPARATUS AND METHOD OF CONTROLLING SUBSTRATE PROCESSING APPARATUS**

(30) Priority: 18.12.2024 JP 2024221494
(71) Applicant: SCREEN Holdings Co., Ltd., Kyoto-shi, Kyoto 602-8585 (JP)
(72) Inventor: KUROEDA, Atsushi, Kyoto, 602-8585 (JP); NISHIDE, Nobuhiko, Kyoto, 602-8585 (JP); NISHIDE, Hajime, Kyoto, 602-8585 (JP); UENO, Tomohiro, Kyoto, 602-8585 (JP)
(74) Representative: Kilian Kilian & Partner mbB

(57) **Abstract**

A substrate processing apparatus includes a processing unit and a transporter. The transporter includes an end effector including a first hand and a second hand and a hand movement driver moving the end effector in a horizontal direction. The first elevating driver moves the first support member to each of a first processing height position where a first direct contact part of the first support member having contact with a lower surface of the substrate is located above the first hand, a second processing height position where the first direct contact part is located between the first hand and the second hand, and a third processing height position where the first direct contact part is located below the second hand.

## Description

### BACKGROUND

### Technical Field

The present disclosure relates to a substrate processing apparatus and a method of controlling a substrate processing apparatus.

### Description of the Background Art

Proposed conventionally is a vacuum processing apparatus performing processing on an LCD substrate made of glass (for example, Japanese Patent Application Laid-Open No. 2001-160584). In Japanese Patent Application Laid-Open No. 2001-160584, a transportation mechanism of transporting the LCD substrate to a processing room is provided. The transportation mechanism includes a catcher with a first fork and a second fork. Each of the first fork and the second fork supports the LCD substrate in a horizontal posture. The first fork and the second fork are provided at an interval in a vertical direction. The first fork is provided above the second fork. The transportation mechanism moves the catcher, thereby integrally moving the first fork and the second fork.

A plurality of first support pins and a plurality of second support pins are provided to the processing room. When the plurality of first support pins moves up while the catcher is located immediately above the plurality of first support pins, the LCD substrate on the second fork can be lifted up by the first support pins.

The plurality of second support pins are provided to an outer side than the plurality of first support pins, and are provided along outside of a peripheral edge of the LCD substrate in a plan view. A distal end portion of the second support pin is bended, and the second support pin is provided to be spun around a rotational axis line in a vertical direction so that a direction of the distal end portion can be changed. When the plurality of second support pins move up in a posture that the distal end portions are directed inward, the distal end portions of the plurality of second support pins have contact with a lower surface of the LCD substrate on the first fork, and can lift up the LCD substrate.

### SUMMARY

Two types of support pins need to be provided in Japanese Patent Application Laid-Open No. 2001-160584. Furthermore, a rotation mechanism for rotating one of the support pins is also necessary. Thus, a configuration of the apparatus is complicated.

Accordingly, an object of the present disclosure is to provide a technique capable of transporting a substrate into and out of a processing chamber by each of a first hand and a second hand with a simple structure.

In one aspect, a substrate processing apparatus includes: a processing unit including a processing chamber, a first support member provided in the processing chamber to support a substrate, and a first elevating driver moving up and down the first support member and performing processing on the substrate in the processing chamber; and a transporter including an end effector including a first hand, a second hand provided below the first hand, and a connection member connecting the first hand and the second hand to fix an interval between the first hand and the second hand, and a hand movement driver moving the end effector between a processing transfer position in the processing chamber and an outside position of the processing chamber along a horizontal direction, wherein the first elevating driver moves the first support member to each of a first processing height position, a second processing height position, and a third processing height position, the first processing height position is a position where a first direct contact part of the first support member having contact with a lower surface of the substrate is located above the first hand, the second processing height position is a position where the first direct contact part is located between the first hand and the second hand, and the third processing height position is a position where the first direct contact part is located below the second hand.

In one aspect, a method of controlling the substrate processing apparatus includes: making the transporter move the end effector to the processing transfer position and making the first elevating driver move the first support member between the first processing height position and the second processing height position or the third processing height position to transport the substrate into or out of the processing chamber with the first hand; and making the transporter move the end effector to the processing transfer position and making the first elevating driver move the first support member between the second processing height position and the third processing height position to transport the substrate into or out of the processing chamber with the second hand.

These and other objects, features, aspects and advantages of the present disclosure will become more apparent from the following detailed description of the present disclosure when taken in conjunction with the accompanying drawings.

### BRIEF DESCRIPTION OF THE DRAWINGS

Fig. 1 is a plan view schematically illustrating an example of a configuration of a substrate processing apparatus.
Fig. 2 is a diagram schematically illustrating an example of an inner configuration of a controller.
Fig. 3 is a vertical cross-sectional view schematically illustrating an example of a specific configuration of a dry processing module.
Fig. 4 is a flow chart illustrating an example of an operation of the dry processing module.
Fig. 5 is a flow chart illustrating an example of an operation of the dry processing module.
Fig. 6 is a diagram schematically illustrating an example of a change of a state of the dry processing module during operation.
Fig. 7 is a diagram schematically illustrating an example of a change of a state of the dry processing module during operation.
Fig. 8 is a diagram schematically illustrating an example of a change of a state of the dry processing module during operation.
Fig. 9 is a diagram schematically illustrating another example of a change of a state of the dry processing module during operation.
Fig. 10 is a diagram schematically illustrating another example of a change of a state of the dry processing module during operation.

### DESCRIPTION OF THE EMBODIMENTS

Embodiments are described hereinafter in detail with reference to the diagrams. It should be noted that dimensions of components and the number of components are illustrated in exaggeration or in simplified form, as appropriate, in the diagrams for the sake of easier understanding. The same reference numerals are assigned to parts having a similar configuration and function, and the repetitive description is omitted in the description hereinafter.

In the description hereinafter, the same reference numerals will be assigned to the similar constituent elements in the diagrams, and the constituent elements having the same reference numeral have the same name and function. Accordingly, the detailed description on them may be omitted to avoid a repetition in some cases.

In the following description, even when ordinal numbers such as "first" or "second" are stated, these terms are used to facilitate understanding of contents of embodiments for convenience, and therefore, the usage of the ordinal numbers does not limit the indication of the ordinal numbers to ordering.

Unless otherwise noted, the expressions indicating relative or absolute positional relationships (e.g., "in one direction", "along one direction", "parallel", "orthogonal", "central", "concentric", and "coaxial") include not only those exactly indicating the positional relationships but also those where an angle or a distance is relatively changed within tolerance or to the extent that similar functions can be obtained. Unless otherwise noted, the expressions indicating equality (e.g., "same", "equal", and "uniform") include not only those indicating quantitatively exact equality but also those in the presence of a difference within tolerance or to the extent that similar functions can be obtained. Unless otherwise noted, the expressions indicating shapes (e.g., "rectangular" or "cylindrical") include not only those indicating geometrically exact shapes but also those indicating, for example, roughness or a chamfer to the extent that similar effects can be obtained. An expression "comprising", "with", "provided with", "including", or "having" a certain constituent element is not an exclusive expression for excluding the presence of the other constituent elements. An expression "at least one of A, B, and C" involves only A, only B, only C, arbitrary two of A, B, and C, and all of A, B, and C.

### <Whole configuration of substrate processing apparatus>

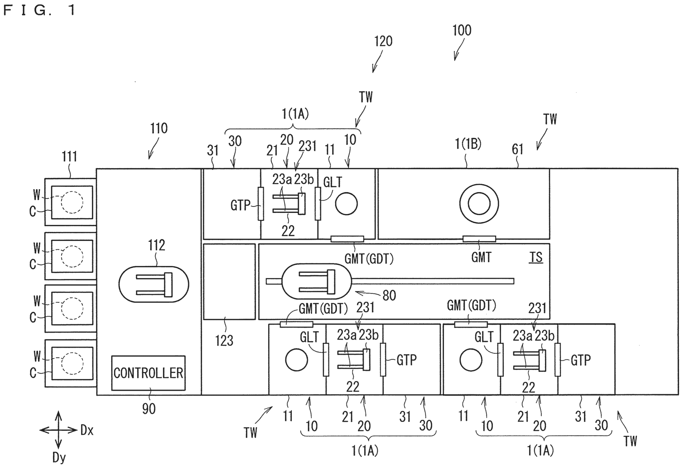

Fig. 1 is a plan view schematically illustrating an example of a configuration of a substrate processing apparatus 100. The substrate processing apparatus 100 is a sheet-like processing apparatus processing a substate W one by one.

The substrate W is a semiconductor wafer, a liquid crystal display apparatus substrate, an electroluminescence (EL) substrate, a flat panel display (FPD) substate, an optical display substrate, a magnetic disk substrate, an optical disk substrate, a magnetic optical disk substrate, a photomask substrate, or a solar battery substrate, for example. The substate W has a thin plate-like shape. In the description hereinafter, the substate W is a semiconductor wafer. The substrate W is a silicon substrate as an example. The substate W is a disk-like shape, for example. A diameter of the substate W is approximately 300 mm, for example, and a thickness of the substate W is approximately equal to or larger than 0.5 mm and approximately equal to or smaller than 3 mm, for example.

In the example in Fig. 1, the substrate processing apparatus 100 includes an indexer block 110, a processing block 120, and a controller 90. The processing block 120 is a part mainly performing processing on the substate W, and the indexer block 110 is a part mainly transporting the substate W between an outer part of the substrate processing apparatus 100 and the processing block 120.

The indexer block 110 includes a load port 111 and an indexer transporter 112. A substrate housing container (referred to as a carrier hereinafter) C is disposed on the load port 111. The plurality of substrates W are housed in the carrier C while being arranged at intervals in a vertical direction, for example. In the example in Fig. 1, the plurality of load ports 111 are arranged.

The indexer transporter 112 is a transfer robot and can take out the unprocessed substrate W from the carrier C disposed on each load port 111. The indexer transporter 112 can also be referred to as an indexer robot. The indexer transporter 112 transports the unprocessed substrate W taken out from the carrier C to the processing block 120. The processing block 120 can perform processing on the unprocessed substate W. The indexer transporter 112 receives the substrate W which has been processed from the processing block 120, and transports the substate W which has been processed to the carrier C of the load port 111.

The processing block 120 includes one or more processing modules 1 and a main transporter 80. In the example in Fig. 1, a plurality of processing modules 1 are provided. The main transporter 80 is a transfer robot, and transports the substrate W between the indexer transporter 112 and the plurality of processing modules 1.

As exemplified in Fig. 1, the processing block 120 may also include a transfer part 123. The transfer part 123 relays the substrate W between the indexer transporter 112 and the main transporter 80. For example, the transfer part 123 includes a shelf on which the plurality of substrates W can be disposed to be arranged in a vertical direction, for example. The indexer transporter 112 places the unprocessed substrate W on the transfer part 123. The main transporter 80 takes out the unprocessed substrate W from the transfer part 123, and transports the unprocessed substrate W to the processing module 1. The processing module 1 performs processing on the substate W.

The plurality of processing modules 1 may include a dry processing module 1A and a wet processing module 1B, or may not include the wet processing module 1B. When the wet processing module 1B is provided, the main transporter 80 may transport the substrate W from one of the dry processing module 1A and the wet processing module 1B to the other one thereof. The dry processing module 1A performs dry processing on the substrate W in a vacuum state, and the wet processing module 1B performs wet processing on the substrate W in an atmospheric pressure state, for example. The main transporter 80 transports the substrate W processed by both the dry processing module 1A and the wet processing module 1B to the transfer part 123, for example.

In the example in Fig. 1, the main transporter 80 is provided in the main transportation space TS. The main transportation space TS extends along a predetermined movement direction Dx. The movement direction Dx is a direction along a horizontal direction, for example. In the example in Fig. 1, the movement direction Dx is a direction perpendicular to an arrangement direction of the load port 111. The horizontal direction perpendicular to the movement direction Dx is also referred to as a width direction Dy (the same as the arrangement direction herein) hereinafter. A size of the movement direction Dx of the main transportation space TS is larger than that of the width direction Dy of the main transportation space TS. That is to say, the main transportation space TS has an elongated shape elongated in the movement direction Dx in a plan view. The plan view herein indicates seeing a target object along the vertical direction.

In the example in Fig. 1, a plurality of processing modules 1 are provided to each of one side and the other side of the main transportation space TS in the width direction Dy. In the example in Fig. 1, the plurality of (two in the diagrams) processing modules 1 are arranged in the movement direction Dx in each side. The plurality of processing modules 1 may be stacked in the vertical direction in a position where each processing module 1 is provided. A part including the plurality of processing modules 1 stacked in the vertical direction is also referred to as a tower TW.

Each processing module 1 includes a module transportation gate GMT. The module transportation gate GMT is provided to a boundary between the processing module 1 and the main transportation space TS. The module transportation gate GMT is an openable and closable transportation port, and its opening and closing are controlled by the controller 90. The module transportation gate GMT may also be a gate valve or a shutter. This point also applies to the other gate described hereinafter. The main transporter 80 stops at a transfer position facing the module transportation gate GMT. Then, the main transporter 80 transports the substrate W into and out of the processing module 1 through the module transportation gate GMT in an open state. In a state where the module transportation gate GMT is closed, an inner space of the processing module 1 is blocked from the main transportation space TS.

The main transporter 80 transports the unprocessed substrate W from the transfer part 123 to the dry processing module 1A. The dry processing module 1A performs dry processing on the substrate W. The dry processing is processing of etching an etching target object on a main surface of the substrate W, for example. There is a case where an impurity remains on the main surface of the substrate W by this dry processing. The main transporter 80 transports the substrate W which has been processed from the dry processing module 1A to the wet processing module 1B. Then, the wet processing module 1B performs wet processing on the substrate W on which the dry processing has been performed. The wet processing is washing processing of removing the impurity on the main surface of the substrate W, for example. At least a part of the impurity of the substrate W can be removed by this wet processing. The main transporter 80 transports the substrate W on which the wet processing has been performed from the wet processing module 1B to the transfer part 123.

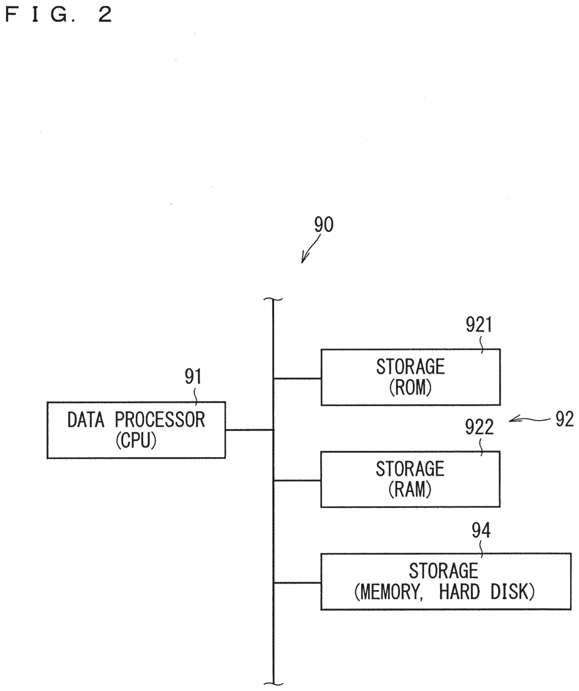

The controller 90 collectively controls the substrate processing apparatus 100. Fig. 2 is a diagram schematically illustrating an example of an inner configuration of the controller 90. The controller 90 is an electrical circuit, and includes a data processor 91 and a storage 92, for example. The data processor 91 and the storage 92 may be mutually connected to each other via a bus 93. The data processor 91 may be an arithmetic processing unit such as a central processor unit (CPU), for example. The storage 92 may include a non-transitory storage (for example, a read only memory (ROM)) 921 and a transitory storage (for example, a random access memory (RAM)) 922. The non-transitory storage 921 may store a program regulating processing executed by the controller 90, for example. When the data processor 91 executes this program, the controller 90 can execute processing regulated by the program. Needless to say, hardware such as a dedicated logic circuit may execute part of or whole processing executed by the controller 90. In the example in Fig. 2, the controller 90 is also connected to a non-transitory storage 94 (a memory such as a flash memory or a hard disk).

### <Dry processing module>

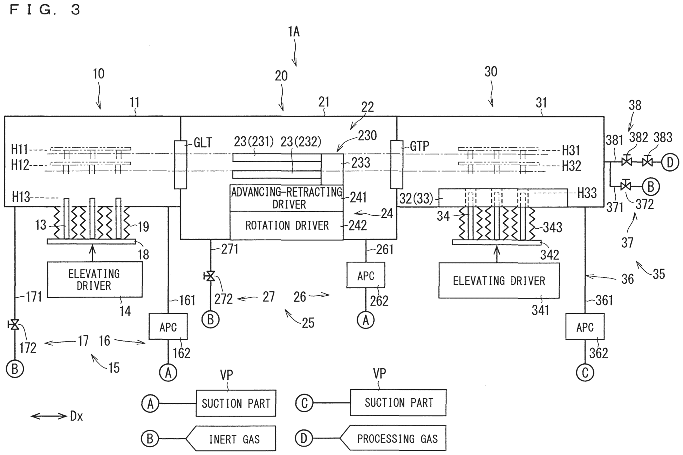

An example of a configuration of the dry processing module 1A is described next as the processing module 1 having a transportation structure according to the present embodiment. Fig. 3 is a vertical cross-sectional view schematically illustrating an example of a specific configuration of the dry processing module 1A. An example of a transportation configuration of the dry processing module 1A is firstly described hereinafter.

As illustrated in Fig. 3, the dry processing module 1A includes a local transporter 22 (corresponding to an example of the transporter) and a dry processing unit 30 (corresponding to an example of the processing unit). The local transporter 22 transports the substrate W to the dry processing unit 30. The dry processing unit 30 performs dry processing (corresponding to an example of the processing) on the substrate W.

As illustrated in Fig. 3, the local transporter 22 includes an end effector 230 and a hand movement driver 24. The end effector 230 includes a plurality of hands 23 and a connection member 233. In the example in Fig. 3, a first hand 231 and a second hand 232 are illustrated as the plurality of hands 23. The first hand 231 and the second hand 232 have a plate-like shape, for example. The first hand 231 and the second hand 232 hold or support the substrate W in a horizontal posture. For example, the substrate W is disposed on the first hand 231 or the second hand 232. The first hand 231 and the second hand 232 are arranged at an interval in the vertical direction. Herein, the second hand 232 is provided below the first hand 231. The interval between the first hand 231 and the second hand 232 is larger than a thickness of the substrate W. The interval may be set to be as narrow as possible. The interval is equal to or smaller than 25 mm, for example.

The first hand 231 and the second hand 232 may have the same shape in a plan view. The first hand 231 and the second hand 232 may be provided to be overlapped with each other in a plan view. The first hand 231 and the second hand 232 are fixed to each other by the connection member 233. That is to say, a relative positional relationship between the first hand 231 and the second hand 232 is constant, and the interval between the first hand and the second hand is fixed.

Also with reference to Fig. 1, the first hand 231 includes one or more elongated member 23a, for example. In an example in Fig. 1, the plurality of (specifically, two) elongated members 23a are provided. The plurality of elongated members 23a are located adjacent to each other in a plan view, and base ends of the plurality of elongated members 23a are connected by the connection member 23b. The second hand 232 may also include the elongated member 23a and the connection member 23b in the similar manner. The connection member 233 is fixed to the connection member 23b of the first hand 231 and the connection member 23b of the second hand 232, for example.

The hand movement driver 24 is controlled by the controller 90, and moves the end effector 230 along the horizontal direction. That is to say, the hand movement driver 24 integrally moves the first hand 231 and the second hand 232 along the horizontal direction. For example, the hand movement driver 24 includes a drive source such as a motor and a power transmission part transmitting drive force of the drive source to the hand 23. The power transmission part includes at least one of an arm mechanism, a ball spring mechanism, a rotation mechanism, and a cam mechanism, for example. As a specific example, the hand movement driver 24 includes an advancing-retracting driver 241 and a rotation driver 242 in Fig. 3.

The advancing-retracting driver 241 moves the end effector 230 along a horizontal one direction (referred to as an advancing-retracting direction hereinafter). The advancing-retracting direction is a direction along a longitudinal direction of the elongated member 23a, for example. The advancing-retracting driver 241 includes a plurality of arms and a motor adjusting a connection angle of the plurality of arms, for example. The end effector 230 is connected to one end of a connector including the plurality of arms, and the other end thereof is connected to the rotation driver 242. When the connection angle of the arm is adjusted, the end effector 230 moves along the advancing-retracting direction. The advancing-retracting driver 241 may include a direct-acting mechanism such as a ball spring mechanism in place of the arm mechanism.

The rotation driver 242 includes a motor, and integrally rotates the end effector 230 and the advancing-retracting driver 241 around a rotational axis line along the vertical direction. A direction of the end effector 230 can be adjusted by this rotation. Specifically, the rotation driver 242 moves the end effector 230 to a processing rotation position in which a distal end of the elongated member 23a is directed to a side of the dry processing unit 30. In this state, the advancing-retracting driver 241 moves the end effector 230 along the advancing-retracting direction. Accordingly, the local transporter 22 can move the end effector 230 between a processing transfer position in a dry processing chamber 31 and an outside position of the dry processing chamber 31. The processing transfer position is a position where the substrate W is transferred between a plurality of elevating pins 34 and the local transporter 22.

In an example in Fig. 3, the hand movement driver 24 does not include an elevating driver moving up and down the end effector 230.

The dry processing unit 30 includes the dry processing chamber 31 (corresponding to an example of the processing chamber), the plurality of elevating pins 34 (corresponding to an example of the first support member), and a pin elevating driver 341 (corresponding to an example of the first elevating driver).

The dry processing chamber 31 forms a processing space for performing dry processing on the substrate W. A transportation processing gate GTP is provided to the dry processing chamber 31. The transportation processing gate GTP is an openable and closable transportation port, and its opening and closing are controlled by the controller 90. The local transporter 22 transports the substrate W into and out of the dry processing chamber 31 as descried hereinafter while the transportation processing gate GTP is opened. The dry processing unit 30 performs dry processing on the substrate W in the dry processing chamber 31 while the transportation processing gate GTP is closed.

The plurality of elevating pins 34 are provided in the dry processing chamber 31 to support the substrate W. Each elevating pin 34 has a rod-like shape extending along the vertical direction, and when distal end portions (corresponding to first direct contact parts) of the plurality of elevating pins 34 have contact with a lower surface of the substrate W, the plurality of elevating pins 34 support the substrate W in the horizontal posture. The horizontal posture herein indicates a posture in which a thickness direction of the substrate W extends along the vertical direction.

The pin elevating driver 341 moves up the plurality of elevating pins 34. The pin elevating driver 341 moves the plurality of elevating pins 34 to at least each of a first height position H31 (corresponding to an example of a first processing height position), a second height position H32 (corresponding to an example of a second processing height position), and a third height position H33 (corresponding to an example of a third processing height position) described next.

The first height position H31 is a position where the distal end portions of the plurality of elevating pins 34 are located above the first hand 231. The substrate W supported at the first height position H31 is located above the first hand 231. The second height position H32 is a position where the plurality of elevating pins 34 can support the substate W between the first hand 231 and the second hand 232. The substrate W supported at the second height position H32 is located away from both the first hand 231 and the second hand 232. The distal end portions of the plurality of elevating pins 34 are located between the first hand 231 and the second hand 232 at the second height position H32. The third height position H33 is a position where the distal end portions of the plurality of elevating pins 34 are located below the second hand 232. A difference (a height width) between the first height position H31 and the third height position H33 is larger than a height width between an upper surface of the first hand 231 and a lower surface of the second hand 232. The difference therebetween is equal to or smaller than 35 mm, for example.

In the example in Fig. 3, the dry processing unit 30 includes a stage 33. The stage 33 is provided in the dry processing chamber 31. The stage 33 has a plate-like shape, and is provided in a posture so that a thickness direction thereof extends along the vertical direction. The substrate W is disposed on the stage 33 in the horizontal posture. The dry processing unit 30 performs dry processing on the substrate W disposed on the stage 33.

In the example in Fig. 3, at least a part of the elevating pins 34 is disposed to pass through the stage 33. The first height position H31 and the second height position H32 are positions where the distal end portions of the plurality of elevating pins 34 are located above an upper surface of the stage 33, and the third height position H33 is a position where the distal end portions of the plurality of elevating pins 34 are located below the upper surface of the stage 33.

The controller 90 controls the pin elevating driver 341. For example, the pin elevating driver 341 includes a drive source such as a motor and a power transmission part transmitting drive force of the drive source to the elevating pins 34. The power transmission part includes a ball spring mechanism, for example.

In such a dry processing module 1A, the local transporter 22 can transport the substrate W into and out of the dry processing chamber 31 using each of the first hand 231 and the second hand 232. This transportation operation is described hereinafter.

Firstly, the controller 90 controls the local transporter 22, thereby rotating the end effector 230 to a processing rotation position. Accordingly, the end effector 230 faces the transportation processing gate GTP. The controller 90 opens the transportation processing gate GTP. Then, the controller 90 makes the local transporter 22 move the end effector 230 to the processing transfer position, makes the pin elevating driver 341 moving up and down the elevating pin 34, and transfers the substrate W between the end effector 230 and the plurality of elevating pins 34. For example, in incoming transportation or outgoing transportation using the first hand 231, the controller 90 makes the pin elevating driver 341 move the plurality of elevating pins 34 between the first height position H31 and the second height position H32 or the third height position H33 as described in detail hereinafter. In the meanwhile, in incoming transportation or outgoing transportation using the second hand 232, the controller 90 makes the pin elevating driver 341 move the plurality of elevating pins 34 between the second height position H32 and the third height position H33 as described in detail hereinafter.

Described firstly is an example of transporting the substrate W into the dry processing chamber 31 using the first hand 231. The substrate W is supported by the first hand 231 herein. The local transporter 22 moves the end effector 230 to the processing transfer position along the horizontal direction. The processing transfer position is a position where the substrate W faces the plurality of elevating pins 34 in the vertical direction. Next, the pin elevating driver 341 moves up the plurality of elevating pins 34 from the third height position H33 to the first height position H31, for example. Accordingly, the substrate W is transferred from the first hand 231 to the plurality of elevating pins 34. Next, the local transporter 22 moves the end effector 230 to the outside position of the dry processing chamber 31. In this manner, the local transporter 22 can transport the substrate W into the dry processing chamber 31 using the first hand 231. Since the stage 33 is provided in the example in Fig. 3, the pin elevating driver 341 moves down the plurality of elevating pins 34 to the third height position H33. Accordingly, the substrate W is transferred to the stage 33.

An example of transporting the substrate W out of the dry processing chamber 31 using the first hand 231 is opposite to the operation described above. That is to say, the pin elevating driver 341 firstly moves up the plurality of elevating pins 34 from the third height position H33 to the first height position H31. Accordingly, the substrate W is transferred from the stage 33 to the plurality of elevating pins 34. Next, the local transporter 22 moves the end effector 230 to the processing transfer position along the horizontal direction. Accordingly, the first hand 231 is stopped immediately below the substrate W. Next, the pin elevating driver 341 moves down the plurality of elevating pins 34 below the first hand 231. For example, the pin elevating driver 341 moves down the plurality of elevating pins 34 to the second height position H32 or the third height position H33. When the plurality of elevating pins 34 are moved down, the substrate W is transferred from the elevating pins 34 to the first hand 231. Next, the local transporter 22 moves the end effector 230 to the outside position of the dry processing chamber 31 along the horizontal direction. In this manner, the local transporter 22 can transport the substrate W out of the dry processing chamber 31 using the first hand 231.

Described next is an example of transporting the substrate W into the dry processing chamber 31 using the second hand 232. The substrate W is supported by the second hand 232 herein. The local transporter 22 moves the end effector 230 to the processing transfer position. Accordingly, the plurality of elevating pins 34 are located immediately below the substrate W. Next, the pin elevating driver 341 moves up the plurality of elevating pins 34 from the third height position H33 to the second height position H32. Accordingly, the substrate W is transferred from the second hand 232 to the plurality of elevating pins 34. Since the elevating pins 34 are located at the second height position H32, the substrate W does not collide with the first hand 231. Next, the local transporter 22 moves the end effector 230 to the outside position of the dry processing chamber 31. In this manner, the local transporter 22 can transport the substrate W into the dry processing chamber 31 using the second hand 232. Since the stage 33 is provided in the example in Fig. 3, the pin elevating driver 341 moves down the plurality of elevating pins 34 to the third height position H33. Accordingly, the substrate W is transferred to the stage 33.

An example of transporting the substrate W out of the dry processing chamber 31 using the second hand 232 is opposite to the operation described above. That is to say, the pin elevating driver 341 firstly moves up the plurality of elevating pins 34 from the third height position H33 to the second height position H32. Accordingly, the substrate W is transferred from the stage 33 to the plurality of elevating pins 34. Next, the local transporter 22 moves the end effector 230 to the processing transfer position. Accordingly, the second hand 232 is stopped immediately below the substrate W. In this state, the first hand 231 is located above the substrate W. That is to say, the substrate W is located between the first hand 231 and the second hand 232. Next, the pin elevating driver 341 moves down the plurality of elevating pins 34 to the third height position H33. When the plurality of elevating pins 34 are moved down, the substrate W is transferred from the elevating pins 34 to the second hand 232. Next, the local transporter 22 moves the end effector 230 to the outside position of the dry processing chamber 31. In this manner, the local transporter 22 can transport the substrate W out of the dry processing chamber 31 using the second hand 232.

As described above, according to the transportation structure of the dry processing module 1A according to the present embodiment, the local transporter 22 includes the first hand 231 and the second hand 232, and the elevating pins 34 are moved to each of the first height position H31, the second height position H32, and the third height position H33. Thus, the dry processing module 1A can transport the substrate W into and out of the dry processing module 1A using each of the first hand 231 and the second hand 232 with a simpler structure. For example, the plural types of support pins and the rotation mechanism of the support pins described in Japanese Patent Application Laid-Open No. 2001-160584 can be unnecessary.

According to the present embodiment, even when the elevating driver for the end effector 230 is not provided to the local transporter 22, the substrate W can be transported between a local transportation unit 20 and the dry processing unit 30 using each of the first hand 231 and the second hand 232. When the elevating driver is not provided to the local transporter 22, a size of the local transporter 22 in the vertical direction can be reduced. That is to say, since the local transporter 22 includes the end effector 230 and the hand movement driver 24, the size thereof in the vertical direction gets large. However, when the elevating driver is omitted, the size of the local transporter 22 in the vertical direction can be effectively reduced. Thus, the size of the dry processing module 1A in the vertical direction can be reduced. This is particularly effective for a structure that the plurality of dry processing modules 1A are stacked in the vertical direction to form the tower TW. That is to say, since the size of each dry processing module 1A is stacked in the tower TW in which the plurality of dry processing modules 1A are stacked in the vertical direction, reduction of the size of each dry processing module 1A is important.

Since the local transporter 22 includes the first hand 231 and the second hand 232, two substrate W can be transported in the dry processing module 1A. For example, as described in detail hereinafter, the local transporter 22 can support the next substrate W with the first hand 231 in a period in which the dry processing unit 30 performs dry processing on the substrate W. Then, when the dry processing unit 30 finishes the dry processing on the substrate W, the substrate W which has been processed can be transported from the dry processing chamber 31 with the second hand 232. When the substrate W which has been processed on the second hand 232 is transported from the local transporter 22, the local transporter 22 can transport the next substrate W on the first hand 231 into the dry processing chamber 31. Accordingly, the next substrate W can be transported into the dry processing chamber 31 more rapidly after the dry processing is finished.

In the example in Fig. 3, the local transporter 22 is provided in a local transportation chamber 21. The local transportation chamber 21 is connected to the dry processing chamber 31 via the transportation processing gate GTP. The outside position of the dry processing chamber 31 described above is a position in the local transportation chamber 21. The unit including the local transporter 22 and the local transportation chamber 21 is also referred to as the local transportation unit 20 hereinafter.

In the example in Fig. 3, the dry processing module 1A also includes a load lock unit 10. In the example in Fig. 3, the load lock unit 10 includes a load lock chamber 11, a plurality of elevating pins 13 (corresponding to an example of the second support member), and a pin elevating driver 14 (corresponding to an example of the second elevating driver).

The load lock chamber 11 is connected to the local transportation chamber 21 via the load transportation gate GLT. The transportation processing gate GTP is an openable and closable transfer port, and its opening and closing are controlled by the controller 90. The rotation driver 242 of the local transporter 22 rotates the end effector 230 also to a load rotation position. The load rotation position is a position at which the distal end of the elongated member 23a faces a side of the load lock unit 10. As described hereinafter, the local transporter 22 transports the substrate W into and out of the load lock chamber 11 through the load transportation gate GLT.

In the example in Fig. 1, the load lock chamber 11 faces the main transportation space TS, and a dry transportation gate GDT as an example of the module transportation gate GMT is provided to a part thereof facing the main transportation space TS. The substrate W is transported between the load lock chamber 11 and the main transporter 80 through the dry transportation gate GDT. That is to say, the load lock chamber 11 forms an interface space of the dry processing module 1A. In the meanwhile, the local transportation chamber 21 forms a relay space for the substrate W between the load lock chamber 11 and the dry processing chamber 31, and the dry processing chamber 31 forms the dry processing space as described above.

In the example in Fig. 1 and Fig. 3, the local transportation chamber 21 is adjacent to the load lock chamber 11 in the movement direction Dx. In the example in Fig. 1 and Fig. 3, the dry processing chamber 31 is adjacent to the local transportation chamber 21 in the movement direction Dx. That is to say, in the example in Fig. 1 and Fig. 3, the load lock chamber 11, the local transportation chamber 21, and the dry processing chamber 31 are arranged in this order in the movement direction Dx. That is to say, in the example in Fig. 1 and Fig. 3, the load lock unit 10 (for example, the load lock chamber 11), the local transportation unit 20 (for example, the local transportation chamber 21), and the dry processing unit 30 (for example, the dry processing chamber 31) are provided one by one in each dry processing module 1A. In other words, each of the load lock unit 10 and the local transportation unit 20 is a unit dedicated to the single dry processing unit 30.

The load lock unit 10 switches the load lock chamber 11 between an atmospheric pressure state and a vacuum state. That is to say, the load lock unit 10 changes the state of the load lock chamber 11 between an atmospheric pressure state and a vacuum state as described hereinafter. The main transporter 80 transports the load lock unit 10 and the substrate W in an atmospheric pressure state. That is to say, the main transporter 80 transports the substrate W into or out of the load lock chamber 11 in the atmospheric pressure state through the dry transportation gate GDT.

As described hereinafter, the local transportation unit 20 can make the local transportation chamber 21 enter the vacuum state, and the dry processing unit 30 can make the dry processing chamber 31 enter the vacuum state. For example, the local transporter 22 transports the substrate W between the load lock chamber 11 and the dry processing chamber 31 in the vacuum state, and the dry processing unit 30 performs processing on the substrate W in the vacuum state.

The plurality of elevating pins 13 are provided in the load lock chamber 11 to support the substrate W. Each elevating pin 13 has a rod-like shape extending along the vertical direction. When distal end portions (corresponding to second direct contact parts) of the plurality of elevating pins 13 have contact with a lower surface of the substrate W, the plurality of elevating pins 13 support the substrate W in the horizontal posture.

The pin elevating driver 14 moves up and down the plurality of elevating pins 13. The pin elevating driver 14 moves the plurality of elevating pins 13 to at least each of a first height position H11 (corresponding to an example of a first load height position), a second height position H12 (corresponding to an example of a second load height position), and a third height position H13 (corresponding to an example of a third load height position) described next. A relative positional relationship between the first height position H11 and the end effector 230 is similar to that between the first height position H31 and the end effector 230. That is to say, the first height position H11 is a position where the distal end portions of the plurality of elevating pins 13 are located above the first hand 231. The same applies to the second height position H32 and the third height position H33. That is to say, the second height position H12 is a position where the distal end portions of the plurality of elevating pins 13 are located between the first hand 231 and the second hand 23, and the third height position H13 is a position where the distal end portions of the plurality of elevating pins 13 are located below the second hand 232.

Since the pin elevating driver 14 can move the plurality of elevating pins 13 from the first height position H11 to the third height position H13, the local transporter 22 can transport the substrate W into and out of the load lock chamber 11 using each of the first hand 231 and the second hand 232. Since a specific operation of this transportation is similar to the operation of transportation into and out of the dry processing chamber 31, a repetitive description is omitted herein.

According to such a dry processing module 1A, the local transporter 22 can transport the substrate W between the load lock chamber 11 and the dry processing chamber 31 using the first hand 231. In this case, the substrate W is moved between the load lock chamber 11 and the dry processing chamber 31 at a height position (a first hand position) of the first hand 231 along the horizontal direction. In the similar manner, the local transporter 22 can also transport the substrate W between the load lock chamber 11 and the dry processing chamber 31 using the second hand 232. In this case, the substrate W is moved between the load lock chamber 11 and the dry processing chamber 31 at a height position (a second hand position) of the second hand 232 along the horizontal direction.

### <Pressure control system>

In the example in Fig. 3, the processing module 1 including the transportation structure according to the present embodiment is the dry processing module 1A. Thus, an example of a configuration of a pressure control system of the dry processing module 1A is also described.

The load lock unit 10 includes a first pressure adjuster 15. The first pressure adjuster 15 adjusts pressure in the load lock chamber 11. For example, the first pressure adjuster 15 adjusts pressure in the load lock chamber 11 to a value within an atmospheric pressure range. Accordingly, the load lock chamber 11 enters the atmospheric pressure state. The atmospheric pressure range is a range including normal atmospheric pressure, and may be equal to or larger than 80 % and equal to or smaller than 120 % of the normal atmospheric pressure as an example. The first pressure adjuster 15 adjusts pressure in the load lock chamber 11 to a value within a vacuum range lower than the atmospheric pressure range. Accordingly, the load lock chamber 11 enters the vacuum state. The vacuum range may be one-tenth of normal atmospheric pressure or less, or may also be one-hundredth of normal atmospheric pressure or less.

In the example in Fig. 3, the first pressure adjuster 15 includes a first gas suction part 16 and a first gas supply part 17. The first gas supply part 17 supplies gas into the load lock chamber 11. The gas is inert gas, for example. The inert gas includes at least one of noble gas and nitrogen gas, for example. The noble gas includes at least one of argon gas and neon gas. The first gas suction part 16 sucks gas from inside the load lock chamber 11.

In the example in Fig. 3, the first gas supply part 17 includes a first supply pipe 171 and a first supply valve 172. A downstream end of the first supply pipe 171 is connected to a bottom part, for example, of the load lock chamber 11. An upstream end of the first supply pipe 171 is connected to an inert gas supply source. The inert gas supply source includes a retention part (not shown) retaining the inert gas. The first supply valve 172 is provided to the first supply pipe 171. The first supply valve 172 is controlled by the controller 90, and switches opening and closing of the first supply pipe 171.

In the example in Fig. 3, the first gas suction part 16 includes a first suction pipe 161, a first pressure adjustment valve 162, and a suction part VP. An upstream end of the first suction pipe 161 is connected to a bottom part, for example, of the load lock chamber 11. A downstream end of the first suction pipe 161 is connected to the suction part VP. The suction part VP is a pump, for example, and is controlled by the controller 90. The suction part VP sucks gas inside the load lock chamber 11 through the first suction pipe 161. The first pressure adjustment valve 162 is provided to the first suction pipe 161. The controller 90 controls the first pressure adjustment valve 162. The first pressure adjustment valve 162 adjusts an opening degree thereof to adjust pressure in the load lock chamber 11. The first pressure adjustment valve 162 is an automatic pressure controller, for example. The first pressure adjustment valve 162 may include a built-in pressure sensor, or a pressure sensor may be provided to the load lock chamber 11. The first pressure adjustment valve 162 adjusts the opening degree thereof in accordance with a detection value of the pressure sensor, thus can adjust pressure in the load lock chamber 11 with higher accuracy. The same applies to the other pressure adjustment valve described hereinafter.

The local transportation unit 20 includes a second pressure adjuster 25. The second pressure adjuster 25 adjusts pressure in the local transportation chamber 21. Specifically, the second pressure adjuster 25 adjusts pressure in the local transportation chamber 21 to a value within a vacuum range. Accordingly, the local transportation chamber 21 enters the vacuum state. The second pressure adjuster 25 includes a second gas suction part 26 and a second gas supply part 27. The second gas supply part 27 supplies gas (for example, inert gas) into the local transportation chamber 21. The second gas suction part 26 sucks gas from inside the local transportation chamber 21. In the example in Fig. 3, the second gas supply part 27 includes a second supply pipe 271 and a second supply valve 272, and the second gas suction part 26 includes a second suction pipe 261, a second pressure adjustment valve 262, and the suction part VP. Since these configurations are similar to those of the first pressure adjuster 15, the detailed description is omitted.

The dry processing unit 30 includes a third pressure adjuster 35. The third pressure adjuster 35 adjusts pressure in the dry processing chamber 31. Specifically, the third pressure adjuster 35 adjusts pressure in the dry processing chamber 31 to a value within a vacuum range. Accordingly, the dry processing chamber 31 enters the vacuum state. The third pressure adjuster 35 includes a third gas suction part 36 and a third gas supply part 37. The third gas supply part 37 supplies gas (for example, inert gas) into the dry processing chamber 31. The third gas suction part 36 sucks gas from inside the dry processing chamber 31. In the example in Fig. 3, the third gas supply part 37 includes a third supply pipe 371 and a third supply valve 372, and the third gas suction part 36 includes a third suction pipe 361, a third pressure adjustment valve 362, and the suction part VP. Since these configurations are similar to those of the first pressure adjuster 15, the detailed description is omitted. In the example in Fig. 3, a downstream end of the third supply pipe 371 is connected to a side part of the dry processing chamber 31.

### <Configuration of processing>

The dry processing unit 30 includes a processing gas supply part 38. The processing gas supply part 38 supplies processing gas into the dry processing chamber 31. The processing gas acts on a main surface (the upper surface herein) of the substrate W disposed on a substrate disposed part 32 (specifically, the stage 33). Accordingly, dry processing corresponding to a type of the processing gas is performed on the main surface of the substrate W. As an example, the processing gas is etching gas. The etching gas removes an etching target object of the substrate W. As a specific example, the processing gas may include hydrogen fluoride gas, and may further include moisture vapor. When the hydrogen fluoride gas (and moisture vapor) acts on an oxide film (a silicon oxide film, for example) of the substrate W, the oxide film can be etched. A component of the processing gas (fluorine, for example) may remain on the main surface of the substrate W by this dry processing, or a residual product or a residual of the etching target object may remain in some cases.

In the example in Fig. 3, the processing gas supply part 38 includes a supply pipe 381, a supply valve 382, and a flow amount adjustment valve 383. A downstream end of the supply pipe 381 is connected to a side part, for example, of the dry processing chamber 31. In the example in Fig. 3, the supply pipe 381 and the third supply pipe 371 join up with a common pipe, and a downstream end of the common pipe is connected to a side part of the dry processing chamber 31. An upstream end of the supply pipe 381 is connected to a processing gas supply source. The processing gas supply source includes a retention part (not shown) retaining the processing gas. The supply valve 382 and the flow amount adjustment valve 383 are provided to the supply pipe 381. The supply valve 382 is controlled by the controller 90, and switches opening and closing of the supply pipe 381. The flow amount adjustment valve 383 is controlled by the controller 90, and adjusts a flow amount of the processing gas flowing in the supply pipe 381. When the processing gas includes plural types of gas, the supply pipe 381, the supply valve 382, and the flow amount adjustment valve 383 corresponding to each type may be provided.

The dry processing unit 30 may include a plasma reactor converting the processing gas into plasma. The plasma reactor may be a capacitive coupled plasma reactor or an inductive coupled plasma reactor, for example. It is also applicable that the dry processing unit 30 makes various active species (ion or radical, for example) included in plasma act on the main surface of the substrate W, thereby performing plasma processing on the substrate W.

In the above example, the hand movement driver 24 of the local transporter 22 does not include an elevating driver moving up and down the end effector 230. In this case, the end effector 230 is not moved up and down. Accordingly, a height width of the load transportation gate GLT and a height width of the transportation processing gate GTP can be reduced. Thus, cost of each gate can be reduced.

An interval between the first hand 231 and the second hand 232 is fixed, and the hand movement driver 24 integrally moves the first hand 231 and the second hand 232 along the horizontal direction. Thus, a size of the local transporter 22 in the vertical direction can be reduced compared with a case of providing a driver individually moving the first hand 231 and the second hand 232, and manufacturing cost of the local transporter 22 can be reduced.

Since the end effector 230 needs not be moved up above the elevating pin 34 in the dry processing chamber 31, a size of the dry processing chamber 31 in the vertical direction can also be reduced. Accordingly, a volume of the dry processing chamber 31 can be reduced. Thus, the third pressure adjuster 35 can adjust pressure in the dry processing chamber 31 with higher accuracy. Since a pressure value in the dry processing chamber 31 has influence on a result of dry processing on the substrate W, the dry processing unit 30 can perform dry processing on the substrate W with higher accuracy. In the similar manner, the first pressure adjuster 5 can adjust pressure in the load lock chamber 11 with higher accuracy.

### <Example of operation of dry processing module>

Described hereinafter is an operation example of a case where three substrates W are sequentially transported into the dry processing module 1A. Hereinafter, the substrate W transported into the dry processing module 1A firstly is referred to as the first substrate W1, the substrate W transported into the dry processing module 1A next to the first substrate W1 is referred to as the second substrate W2, and the substrate W transported into the dry processing module 1A next to the second substrate W2 is referred to as the third substrate W3.

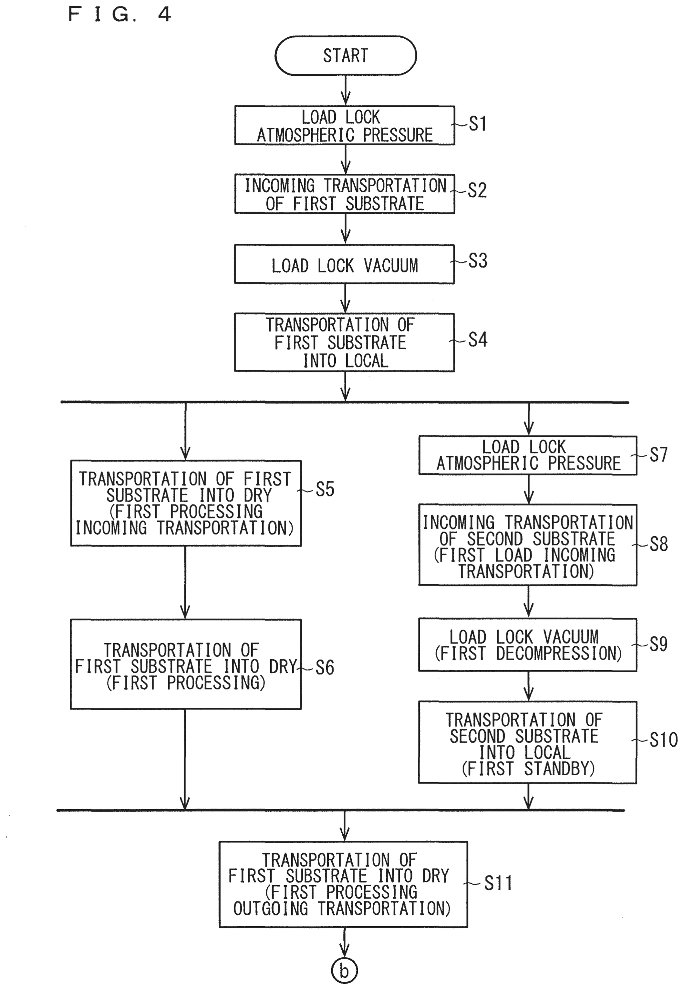

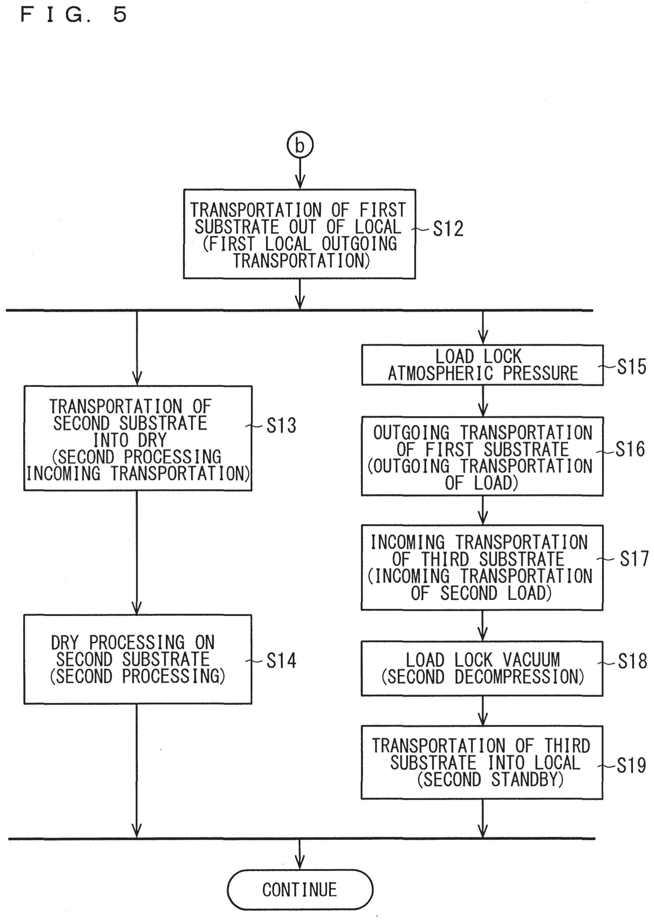

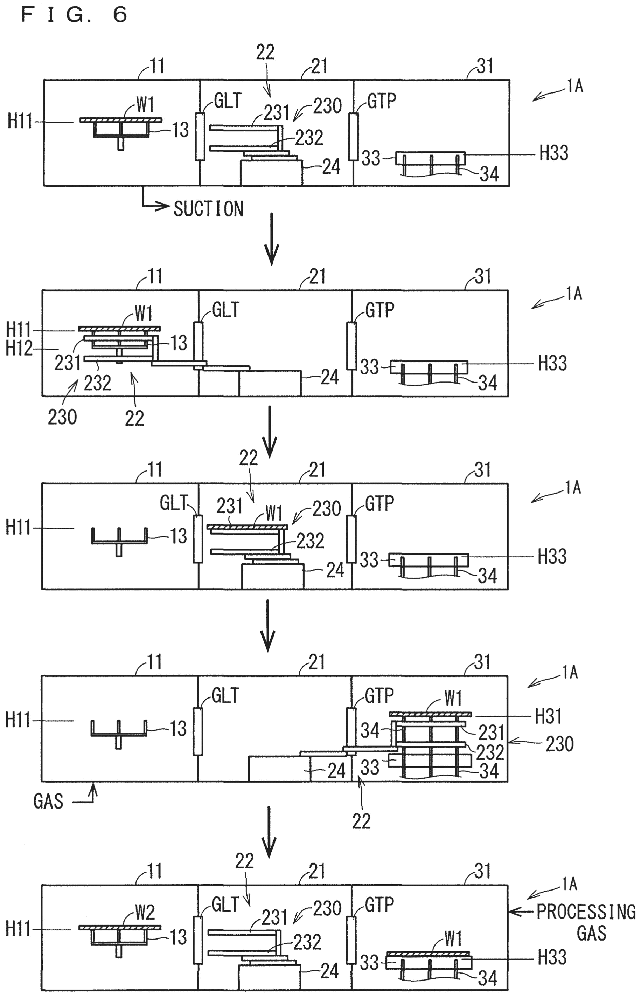

Fig. 4 and Fig. 5 are flow charts each illustrating an example of an operation of the dry processing module 1A. Fig. 6 to Fig. 8 are diagrams schematically illustrating an example of a change of a state of the dry processing module 1A during operation. Herein initially, the first pressure adjuster 15 adjusts pressure in the load lock chamber 11 to a value within a vacuum range, the second pressure adjuster 25 adjusts pressure in the local transportation chamber 21 to a value within a vacuum range, and the third pressure adjuster 35 adjusts pressure in the dry processing chamber 31 to a value within a vacuum range.

The controller 90 firstly controls the first pressure adjuster 15, thereby adjusting pressure in the load lock chamber 11 within an atmospheric pressure range (Step S1). For example, the controller 90 opens the first supply valve 172, and closes the first pressure adjustment valve 162. Accordingly, inert gas is supplied into the load lock chamber 11, and pressure in the load lock chamber 11 increases.

Next, the controller 90 opens the dry transportation gate GDT, and controls the main transporter 80, thereby transporting the unprocessed first substrate W1 into the load lock chamber 11 (Step S2). Accordingly, as illustrated in an uppermost stage in Fig. 6, the first substrate W1 is supported by the plurality of elevating pins 13. In the example in Fig. 6, the plurality of elevating pins 13 are stopped at the first height position H11.

Next, the controller 90 closes the transportation dry gate GTD, and controls the first pressure adjuster 15, thereby reducing pressure in the load lock chamber 11 to a value within a vacuum range (Step S3). For example, the controller 90 controls the first pressure adjustment valve 162 while opening the first supply valve 172. Accordingly, gas in the load lock chamber 11 is mainly sucked, and pressure in the load lock chamber 11 is reduced. The first pressure adjustment valve 162 dynamically adjusts the opening degree in accordance with the pressure in the load lock chamber 11, thus can adjust the pressure within the vacuum range with higher accuracy.

Next, the controller 90 opens the load transportation gate GLT, and controls the pin elevating driver 14 and the local transporter 22, thereby transporting the first substrate W1 from the load lock chamber 11 into the local transportation chamber 21 with one of the first hand 231 and the second hand 232 (Step S4). Herein, the first hand 231 is used as an example. In this case, the controller 90 firstly controls the local transporter 22, thereby moving the end effector 230 to a load transfer position. Accordingly, as illustrated in a second top stage in Fig. 6, the first hand 231 is located immediately below the first substrate W1. The controller 90 controls the pin elevating driver 14, thereby moving down the plurality of elevating pins 13 to the second height position H12 or the third height position H13. Accordingly, the first substrate W1 is transferred from the plurality of elevating pins 13 to the first hand 231. Then, as illustrated in a third top stage in Fig. 6, the controller 90 controls the local transporter 22, thereby moving the end effector 230 into the local transportation chamber 21, and closes the load transportation gate GLT.

Next, the controller 90 opens the transportation processing gate GTP, and controls the local transporter 22 and the pin elevating driver 341, thereby transporting the first substrate W1 into the dry processing chamber 31 (Step S5: first processing incoming transportation step). Herein, the first substrate W1 is transported into the dry processing chamber 31 with the first hand 231. Specifically, the controller 90 controls the local transporter 22, thereby moving the end effector 230 to the processing transfer position, and then controls the pin elevating driver 341, thereby moving up the plurality of elevating pins 34 from the third height position H33 to the first height position H31, for example. Accordingly, as illustrated in a fourth top stage in Fig. 6, the first substrate W1 is transferred from the first hand 231 to the plurality of elevating pins 34. Next, the controller 90 controls the local transporter 22, thereby moving the end effector 230 into the local transportation chamber 21, and then controls the pin elevating driver 341, thereby moving down the plurality of elevating pins 34 to the third height position H33. Accordingly, as illustrated in a lowermost stage in Fig. 6, the first substrate W1 is transferred to the stage 33. Then, the controller 90 closes the transportation processing gate GTP.

Next, the controller 90 controls the third pressure adjuster 35 and the processing gas supply part 38, thereby performing dry processing on the first substrate W1 in the dry processing chamber 31 (Step S6: first processing step). For example, the controller 90 controls the third pressure adjuster 35, thereby adjusting pressure in the dry processing chamber 31 within a processing range appropriate for processing, and also controls the processing gas supply part 38, thereby supplying processing gas into the dry processing chamber 31. The processing gas acts on the main surface of the substate W. Accordingly, processing corresponding to a type of the processing gas is performed on the substrate W.

In the meanwhile, the controller 90 controls the first pressure adjuster 15 after closing the load transportation gate GLT, thereby adjusting pressure in the load lock chamber 11 within an atmospheric pressure range (Step S7). Step S7 is similar to Step S4. In the example in Fig. 4, Step S7 is performed in parallel to at least a part of Step S5 and Step S6. For example, as illustrated in the fourth top stage in Fig. 6, the first pressure adjuster 15 supplies inert gas into the load lock chamber 11 while transporting the first substrate W1 into the dry processing unit 30, and adjusts pressure in the load lock chamber 11 within an atmospheric pressure range.

Next, the controller 90 opens the dry transportation gate GDT, and controls the main transporter 80, thereby transporting the unprocessed second substrate W2 into the load lock chamber 11 (Step S8: first load transportation step). In the example in Fig. 4, Step S8 is performed in parallel to at least a part of Step S5 and Step S6. For example, as illustrated in the lowermost stage in Fig. 6, the main transporter 80 transports the second substrate W2 into the load lock chamber 11 while performing dry processing on the first substrate W1. Accordingly, the second substrate W2 is supported by the plurality of elevating pins 13. In the example in Fig. 6, the plurality of elevating pins 13 are located in the first height position H11. Then, the controller 90 closes the dry transportation gate GDP.

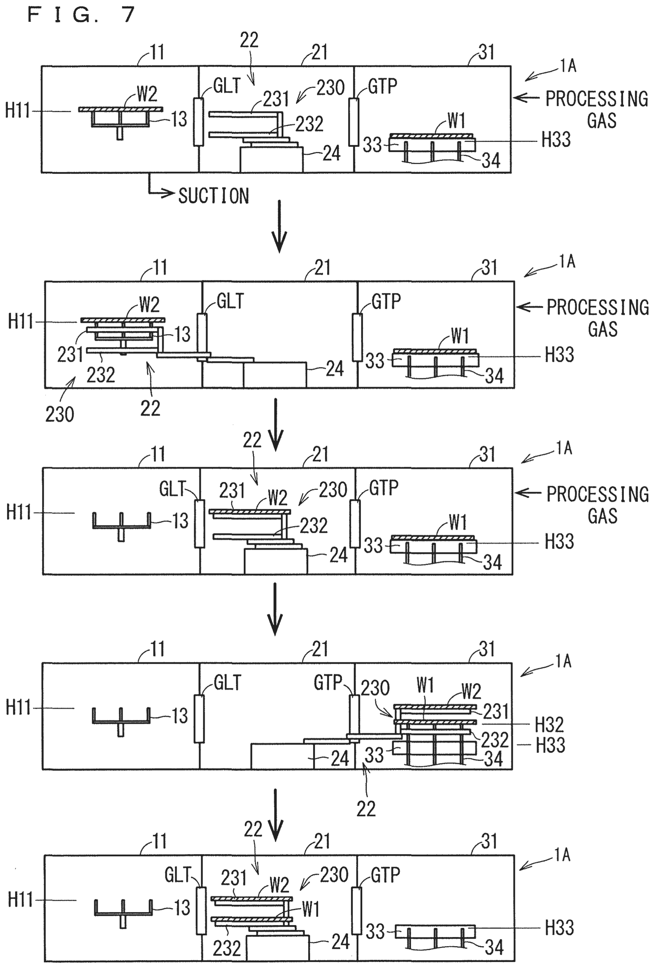

Next, the controller 90 controls the first pressure adjuster 15, thereby reducing pressure in the load lock chamber 11 to a value within a vacuum range (Step S9: first decompression step). Step S9 is similar to Step S3. In the example in Fig. 4, Step S9 is performed in parallel to at least a part of Step S5 and Step S6. For example, as illustrated in an uppermost stage in Fig. 7, the first pressure adjuster 15 sucks gas in the load lock chamber 11 while performing dry processing on the first substrate W1, and reduces pressure in the load lock chamber 11 to within a vacuum range.

After both Step S5 and Step S9 are finished, the second substrate W2 is made to stand by at the plurality of elevating pins 13 or the first hand 231 (Step S10: first standby step) until dry processing on the first substrate W1 is finished (that is to say, Step S6 is finished). Herein, the second substrate W2 is made to stand by at the first hand 231. Then, as illustrated in second and third top stages in Fig. 7, the controller 90 firstly opens the load transportation gate GLT, and controls the pin elevating driver 14 and the local transporter 22, thereby transporting the second substrate W2 from the load lock chamber 11 into the local transportation chamber 21 with the first hand 231. Accordingly, the second substrate W2 is supported by the first hand 231 in the local transportation chamber 21. The second substrate W2 stands by on the first hand 231 in the local transportation chamber 21 until dry processing on the first substrate W1 is finished.

When dry processing is sufficiently performed on the first substrate W1, the controller 90 controls the processing gas supply part 38, thereby stopping supplying processing gas. Accordingly, dry processing is finished.

Next, the controller 90 opens the transportation processing gate GTP, and controls the local transporter 22 and the pin elevating driver 341, thereby transporting the first substrate W1 from the dry processing chamber 31 (Step S11: first processing outgoing transportation step). The first substrate W1 is transferred to the other one of the first hand 231 and the second hand 232 (that is to say, the hand on which the second substrate W2 is not disposed). Herein, the first substrate W1 is transferred to the second hand 232.

Specifically, the controller 90 firstly controls the pin elevating driver 341, thereby moving up the plurality of elevating pins 34 from the third height position H33 to the second height position H32. Accordingly, the first substrate W1 is transferred from the stage 33 to the plurality of elevating pins 34. Then, the controller 90 controls the local transporter 22, thereby moving the end effector 230 to the processing transfer position. Accordingly, as illustrated in the third top stage in Fig. 7, the second hand 232 is located immediately below the first substrate W1. In other words, the first substrate W1 is located between the first hand 231 and the second hand 232. Next, the controller 90 controls the pin elevating driver 341, thereby moving down the plurality of elevating pins 34 to the third height position H33. Accordingly, the first substrate W1 is transferred from the plurality of elevating pins 34 to the second hand 232. Then, the controller 90 controls the local transporter 22, thereby moving the end effector 230 into the local transportation chamber 21, and closes the transportation processing gate GTP. Accordingly, as illustrated in a lowermost stage in Fig. 7, the first substrate W1 and the second substrate W2 are supported by the first hand 231 and the second hand 232, respectively, in the local transportation chamber 21.

As described above, the local transporter 22 transports the first substrate W1 out of the dry processing chamber 31 with the second hand 232 while the first hand 231 supports the second substrate W2.

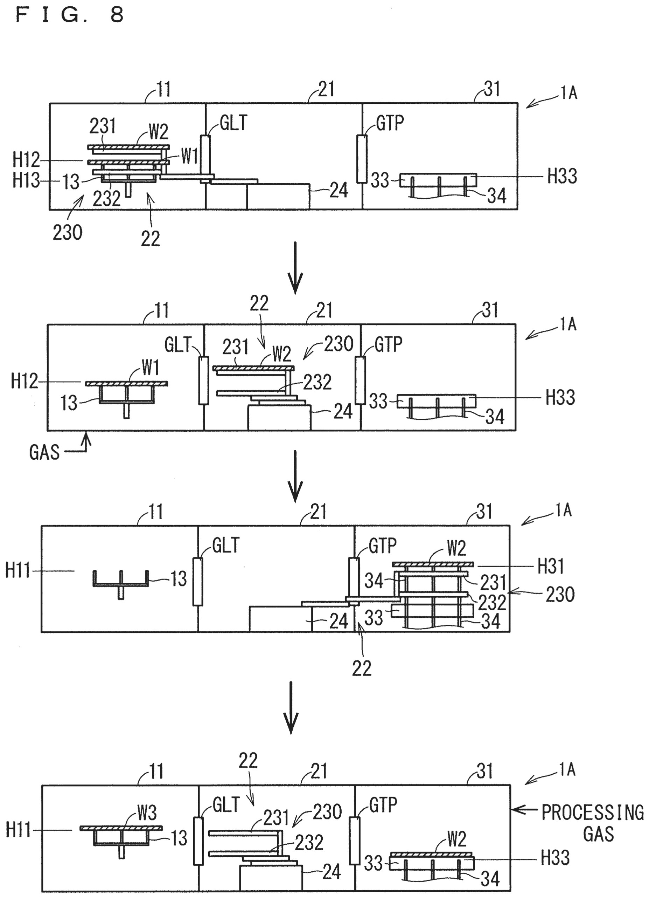

Next, the controller 90 opens the load transportation gate GLT, and controls the pin elevating driver 14 and the local transporter 22, thereby transporting the first substrate W1 from the local transportation chamber 21 (Step S12: first local outgoing transportation step). Specifically, the controller 90 firstly controls pin elevating driver 14, thereby moving down the plurality of elevating pins 13 to the third height position H13, and then controls the local transporter 22, thereby moving the end effector 230 to the load transfer position. Accordingly, the plurality of elevating pins 13 are located immediately below the first substrate W1. Next, the controller 90 controls the pin elevating driver 14, thereby moving up the plurality of elevating pins 13 to the second height position H12. Accordingly, as illustrated in an uppermost stage in Fig. 8, the first substrate W1 is transferred from the second hand 232 to the plurality of elevating pins 13. Then, the controller 90 controls the local transporter 22, thereby moving the end effector 230 into the local transportation chamber 21, and closes the load transportation gate GLT. Accordingly, as illustrated in a second top stage in Fig. 8, the first substrate W1 which has been processed is supported by the elevating pin 13 in the load lock chamber 11, and the unprocessed second substrate W2 is supported by the first hand 231 in the local transportation chamber 21.

As described above, the local transporter 22 transports the first substrate W1 from the local transportation chamber 21 to the load lock chamber 11 with the second hand 232 while the first hand 231 supports the second substrate W2.

Next, the controller 90 controls the local transporter 22 and the pin elevating driver 341, thereby transporting the second substrate W2 into the dry processing chamber 31 (Step S13: second processing incoming transportation step). Specifically, the controller 90 controls the local transporter 22, thereby moving the end effector 230 to the processing transfer position. Accordingly, the plurality of elevating pins 34 are located immediately below the second substrate W2. Then, the controller 90 controls the pin elevating driver 341, thereby moving up the plurality of elevating pins 34 to the first height position H31. Accordingly, as illustrated in a third top stage in Fig. 8, the second substrate W2 is transferred from the first hand 231 to the plurality of elevating pins 34. Next, the controller 90 controls the local transporter 22, thereby moving the end effector 230 into the local transportation chamber 21, and then controls the pin elevating driver 341, thereby moving down the plurality of elevating pins 34 to the third height position H33. Accordingly, the second substrate W2 is transferred to the stage 33. Then, the controller 90 closes the transportation processing gate GTP.

Next, the controller 90 controls the third pressure adjuster 35 and the processing gas supply part 38, thereby performing dry processing on the second substrate W2 in the dry processing chamber 31 (Step S14). Step S14 is similar to Step S6.

In the meanwhile, after Step S12, the controller 90 controls the first pressure adjuster 15, thereby increasing pressure in the load lock chamber 11 to within an atmospheric pressure range (Step S15). Step S15 is similar to Step S1. In the example in Fig. 5, Step S15 is performed in parallel to at least a part of Step S13 and Step S14. For example, as illustrated in the second top stage in Fig. 8, the first pressure adjuster 15 supplies inert gas into the load lock chamber 11 immediately after the load transportation gate GLT is closed in accordance with transportation of the second substrate W2 into the local transportation chamber 21, and increases pressure in the load lock chamber 11.

Next, the controller 90 controls the main transporter 80, thereby transporting the first substrate W1 from the load lock chamber 11 (Step S16: load outgoing transportation). In the example in Fig. 5, Step S16 is performed in parallel to at least a part of Step S13 and Step S14. For example, as illustrated in the third top stage in Fig. 8, the main transporter 80 transports the first substrate W1 from the load lock chamber 11 while the second substrate W2 is transported to the dry processing unit 30. Accordingly, there is no first substrate W1 in the load lock chamber 11.

Next, the controller 90 controls the main transporter 80, thereby transporting the third substrate W3 to the load lock unit 10 (Step S17: second load incoming transportation). In the example in Fig. 5, Step S17 is performed in parallel to at least a part of Step S13 and Step S14. For example, as illustrated in the top stage to the lowermost stage in Fig. 8, the main transporter 80 transports the third substrate W3 into the load lock chamber 11 while performing dry processing on the second substrate W2. Accordingly, the third substrate W3 is supported by the plurality of elevating pins 13.

Next, the controller 90 controls the first pressure adjuster 15, thereby reducing pressure in the load lock chamber 11 to a value within a vacuum range (Step S18: second decompression). Step S18 is similar to Step S3. In the example in Fig. 5, Step S18 is performed in parallel to at least a part of Step S13 and Step S14. For example, the first pressure adjuster 15 sucks gas in the load lock chamber 11 while performing dry processing on the second substrate W2, and reduces pressure in the load lock chamber 11.

After both Step S13 and Step S18 are finished, the third substrate W3 is made to stand by on the plurality of elevating pins 13 or the first hand 231 (Step S19: second standby). Herein, the third substrate W3 is made to stand by at the first hand 231. Specifically, the controller 90 firstly opens the load transportation gate GLT, and controls the pin elevating driver 14 and the local transporter 22, thereby transporting the third substrate W3 into the local transportation chamber 21 with the first hand 231. The third substrate W3 stands by on the first hand 231 in the local transportation chamber 21 until dry processing on the second substrate W2 is finished.

Subsequently, Step S11 to Step S19 are repetitively performed on the subsequent substrate W.

As described above, according to the above transportation operation, the subsequent substrate W (for example, the second substrate W2) is transported into the load lock chamber 11 (Step S8) in parallel to at least a part of transportation of the antecedent substrate W (for example, the first substrate W1) into the dry processing chamber 31 (Step S5) and dry processing on the antecedent substrate W (Step S6). Pressure in the load lock chamber 11 is also reduced to within a vacuum range (Step S9) in parallel to at least a part of transportation of the antecedent substrate W (for example, the first substrate W1) into the dry processing chamber 31 (Step S5) and dry processing on the antecedent substrate W (Step S6). Then, the subsequent substrate W stands by in the vacuum state until dry processing on the antecedent substrate W is finished. That is to say, in the example described above, adjustment of pressure between atmospheric pressure and vacuum for transporting the subsequent substrate W (Step S7 and Step S9) is completed up to a time of finishing dry processing on the antecedent substrate W (Step S6). Accordingly, the subsequent substrate W can be transported into the dry processing chamber 31 (Step S12) in a shorter time after dry processing on the antecedent substrate W is finished. Accordingly, throughput of the substrate processing apparatus 100 can be improved.

In the example described above, the subsequent substrate W stands by on the first hand 231 in the local transportation chamber 21 immediately before the dry processing chamber 31. Thus, there is no substrate W in the load lock chamber 11. Accordingly, the antecedent substrate W can be transported from the dry processing chamber 31 into the load lock chamber 11 more rapidly after dry processing on the antecedent substrate W is finished. As a result, the subsequent substrate W can be transported into the dry processing chamber 31 more rapidly.

When the dry processing is etching processing of etching an etching target film of the substrate W, for example, a residual product in association with reaction of processing gas with the substrate W adheres to the substrate W as an impurity in some cases.

Thus, in the example described above, in Step S5, the unprocessed substrate W is transported into the dry processing chamber 31 with one of the first hand 231 and the second hand 232 (for example, the first hand 231), and in Step S11, the substrate W which has been processed is transported from the dry processing chamber 31 with the other one of the first hand 231 and the second hand 232 (for example, the second hand 232). According to this configuration, the first hand 231 and the second hand 232 can be used differently for the unprocessed substrate W and the substrate W which has been processed. Thus, adhesion of the impurity adhering to the substrate W which has been processed to the unprocessed substrate W via the first hand 231 or the second hand 232 can be avoided.

In the example described above, the unprocessed substrate W is transported with the first hand 231, and the substrate W which has been processed is transported with the second hand 232. In this case, the first hand 231 is deemed to be a hand dedicated to the unprocessed substrate and the second hand 232 is deemed to be a hand dedicated to the substrate which has been processed. Since the first hand 231 is provided above the second hand 232, the unprocessed substrate W is transported at a higher position than the substrate W which has been processed along the horizontal direction. Accordingly, even when the impurity adhering to the substrate W which has been processed drops in transporting the substrate W which has been processed in the horizontal direction, a transportation route of the unprocessed substrate W is not contaminated. Thus, a possibility of adhesion of the impurity to the unprocessed substrate W can be reduced.

In the example described above, the unprocessed substrate W is transported by the first hand 231, and the substrate W which has been processed is transported by the second hand. However, when the substrate W which has been processed is cleaner than the unprocessed substrate W, for example, it is also applicable to transport the unprocessed substrate W by the second hand 232 and transport the substrate W which has been processed by the first hand 231. In this case, the second hand 232 is deemed to be a hand dedicated to the unprocessed substrate and the first hand 231 is deemed to be a hand dedicated to the substrate which has been processed. In this case, as described in detail hereinafter, the subsequent substrate W stands by on the plurality of elevating pins 13 in the vacuum state in the load lock chamber 11 during dry processing on the antecedent substrate W.

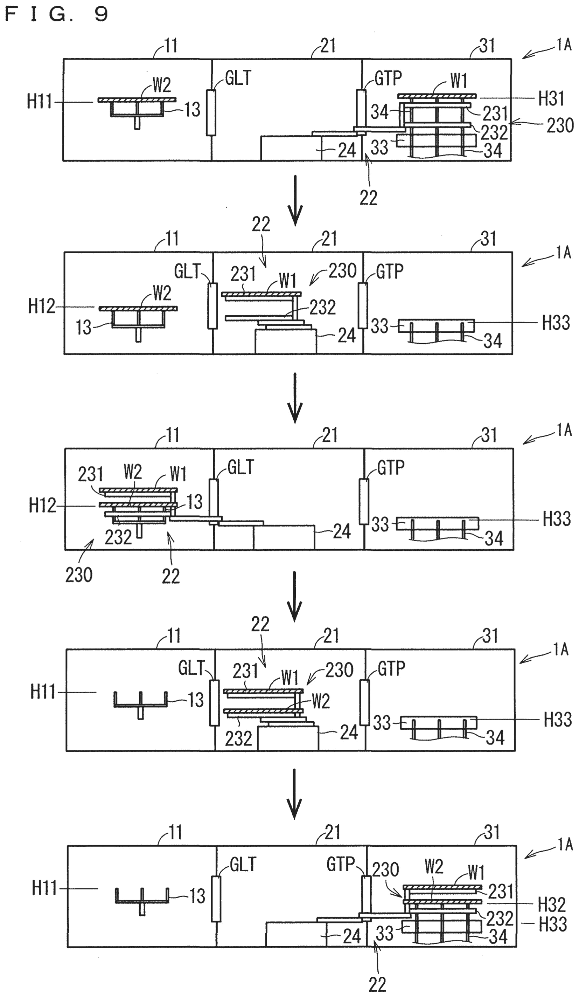

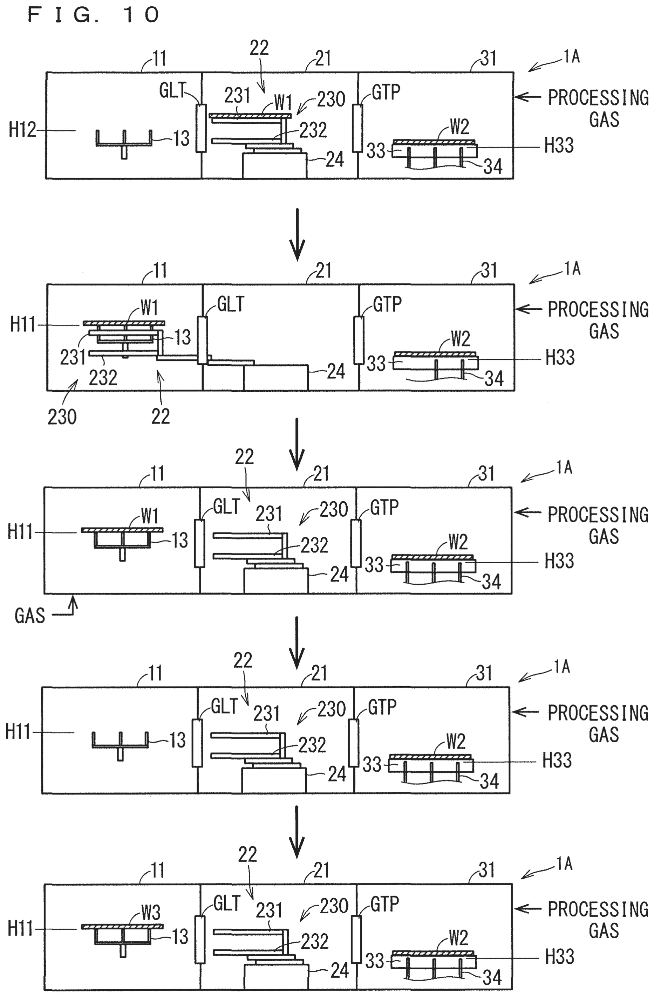

Fig. 9 and Fig. 10 are diagrams schematically illustrating the other example of change of the dry processing module 1A during operation. Fig. 9 and Fig. 10 illustrate an example of a case where the second hand 232 supports the unprocessed substrate W. As illustrated in Fig. 9, after dry processing on the first substrate W1 is finished, the controller 90 controls the pin elevating driver 341 and the local transporter 22, thereby transporting the first substrate W1 from the dry processing chamber 31 with the first hand 231. Next, the controller 90 controls the pin elevating driver 14 and the local transporter 22, thereby transporting the unprocessed second substrate W2 from the load lock chamber 11 into the local transportation chamber 21 with the second hand 232, and controls the pin elevating driver 341 and the local transporter 22, thereby transporting the second substrate W2 into the dry processing chamber 31. As described above, the local transporter 22 transports the second substrate W2 from the load lock chamber 11 into the dry processing chamber 31 with the second hand 232 while the first hand 231 supports the first substrate W1.

Then, as illustrated in Fig. 10, the controller 90 controls the third pressure adjuster 35 and the processing gas supply part 38, thereby performing dry processing on the second substrate W2 in the dry processing chamber 31. During this dry processing, the controller 90 controls the pin elevating driver 14 and the local transporter 22, thereby transporting the first substrate W1 into the load lock chamber 11 with the first hand 231. Then, the controller 90 controls the first pressure adjuster 15, thereby increasing pressure in the load lock chamber 11 to within an atmospheric pressure range during dry processing on the second substrate W2. Next, the controller 90 controls the main transporter 80, thereby transporting the first substrate W1 out of the load lock chamber 11, and transporting the third substrate W3 into the load lock chamber 11. Then, the controller 90 controls the first pressure adjuster 15, thereby reducing pressure in the load lock chamber 11 to within a vacuum range during dry processing on the second substrate W2. The third substrate W3 stands by on the plurality of elevating pins 13 in a vacuum state until dry processing on the second substrate W2 is finished. Subsequently, the similar operation is sequentially performed on the substrate W.

### <Bellows>

In the example in Fig. 3, the pin elevating driver 14 is provided to an external space of the load lock chamber 11. In the example in Fig. 3, lower ends of the plurality of elevating pins 13 are connected to an upper surface of the support plate 18. The support plate 18 has a plate-like shape, for example, and is provided in a posture so that a thickness direction thereof extends along the vertical direction. In the example in Fig. 3, an opening is formed in a bottom part of the load lock chamber 11, and the plurality of elevating pins 13 are disposed to pass through the opening. In the example in Fig. 3, a bellows 19 is provided between the bottom part of the load lock chamber 11 and the support plate 18. The bellows 19 has a cylindrical accordion-like shape. In the example in Fig. 3, the plurality of bellows 19 surrounding lower parts of the plurality of elevating pins 13, respectively, are provided. The bellows 19 is deformable in the vertical direction. That is to say, a size of the bellows 19 in the vertical direction is changeable. An upper end peripheral edge of the bellows 19 is connected to a peripheral edge part of the opening of the load lock chamber 11, and a lower end peripheral edge of the bellows 19 is connected to a peripheral edge of the support plate 18.

The pin elevating driver 14 is provided below the support plate 18. The pin elevating driver 14 is connected to the support plate 18, and moves up and down the support plate 18. Accordingly, the plurality of elevating pins 13 connected to the support plate 18 are moved up and down.

The pin elevating driver 14 is provided outside the load lock chamber 11, thus can be disposed in an atmospheric pressure space. Thus, reliability of the pin elevating driver 14 can be increased. As illustrated in Fig. 3, the bellows 19 is provided to the elevating pin 13 one by one. According to this configuration, a volume of a vacuum part in the load lock chamber 11 can be reduced compared with a structure that a single bellows surrounding the plurality of elevating pins 13 is provided. Thus, the first pressure adjuster 15 can adjust pressure in the load lock chamber 11 with higher accuracy.

In the example in Fig. 3, the pin elevating driver 341 is provided to an external space of the dry processing chamber 31. In the example in Fig. 3, lower ends of the plurality of elevating pins 34 are connected to an upper surface of the support plate 342, and a bellows 343 is provided between a bottom part of the dry processing chamber 31 and the support plate 342. In the example in Fig. 3, the plurality of bellows 343 surrounding lower parts of the plurality of elevating pins 34, respectively, are provided. These are similar to the support plate 18 and the bellows 19, respectively.

Although the substrate processing apparatus 100 and the method of controlling the substrate processing apparatus 100 are described above in detail, the foregoing description is in all aspects illustrative and does not restrict the disclosure. The various modification examples described above can be applied in combination as long as they are not contradictory. It is therefore understood that numerous modification examples can be devised without departing from the scope of the disclosure.

The present disclosure includes the following aspects.

A first aspect is a substrate processing apparatus including: a processing unit including a processing chamber, a first support member provided in the processing chamber to support a substrate, and a first elevating driver moving up and down the first support member and performing processing on the substrate in the processing chamber; and a transporter including an end effector including a first hand, a second hand provided below the first hand, and a connection member connecting the first hand and the second hand to fix an interval between the first hand and the second hand, and a hand movement driver moving the end effector between a processing transfer position in the processing chamber and an outside position of the processing chamber along a horizontal direction, wherein the first elevating driver moves the first support member to each of a first processing height position, a second processing height position, and a third processing height position, the first processing height position is a position where a first direct contact part of the first support member having contact with a lower surface of the substrate is located above the first hand, the second processing height position is a position where the first direct contact part is located between the first hand and the second hand, and the third processing height position is a position where the first direct contact part is located below the second hand.

A second aspect is the substrate processing apparatus according to the first aspect, further comprising a load lock unit including a load lock chamber and switching the load lock chamber between an atmospheric pressure state and a vacuum state, wherein the transporter is provided in a local transportation chamber, the processing unit performs processing on the substrate in the processing chamber in a vacuum state, the transporter transports the substrate between the load lock chamber and the processing chamber in a vacuum state, the load lock unit further includes: a second support member provided in the load lock chamber to support the lower surface of the substrate; and a second elevating driver moving up and down the second support member, and the second elevating driver moves the second support member to each of a first load height position, a second load height position, and a third load height position, the first load height position is a position where a second direct contact part of the second support member having contact with the lower surface of the substrate is located above the first hand, the second load height position is a position where the second direct contact part is located between the first hand and the second hand, and the third load height position is a position where the second direct contact part is located below the second hand.

A third aspect is the substrate processing apparatus according to the first or second aspect, wherein the hand movement driver does not include an elevating driver moving up and down the end effector.

A fourth aspect is a method of controlling the substrate processing apparatus according to any one of the first to third aspects, including: making the transporter move the end effector to the processing transfer position and making the first elevating driver move the first support member between the first processing height position and the second processing height position or the third processing height position to transport the substrate into or out of the processing chamber with the first hand; and making the transporter move the end effector to the processing transfer position and making the first elevating driver move the first support member between the second processing height position and the third processing height position to transport the substrate into or out of the processing chamber with the second hand.

A fifth aspect is the method of controlling the substrate processing apparatus according to the fourth aspect, including: a first processing incoming transportation step of transporting the substrate into the processing chamber with one of the first hand and the second hand; a first processing step of performing processing on the substrate in the processing chamber; and a first processing outgoing transportation step of transporting the substrate out of the processing chamber with another one of the first hand and the second hand.

A sixth aspect is the method of controlling the substrate processing apparatus according to the second aspect, including: a first processing incoming transportation step of transporting a first substrate into the processing chamber with one of the first hand and the second hand; a first processing step of performing processing on the first substrate in the processing chamber; a first load incoming transportation step of transporting a second substrate, which is supported by the second support member, into the load lock chamber performed in parallel to at least a part of the first processing incoming transportation step and the first processing step; a first decompression step of reducing pressure in the load lock chamber to within a vacuum range after the first load incoming transportation step; a first standby step of making the second substrate stand by at a second support member or the first hand until the first processing step is finished; and a first processing outgoing transportation step of transporting the first substrate from the processing chamber into the local transportation chamber with another one of the first hand and the second hand.

A seventh aspect is the method of controlling the substrate processing apparatus according to the sixth aspect, wherein the first substrate is transported into the processing chamber with the first hand in the first processing incoming transportation step, the second substrate is transported from the load lock chamber into the local transportation chamber with the first hand in the first standby step, and the first substrate is transported out of the processing chamber with the second hand in the first processing outgoing transportation step, the method further comprising: a first local outgoing transportation step of transporting the first substrate from the local transportation chamber into the load lock chamber with the second hand after the first processing outgoing transportation step; and a second processing incoming transportation step of transporting the second substrate into the processing chamber with the first hand after the first local outgoing transportation step.

According to the first aspect, the substrate can be transported into and out of the processing chamber using each of the first hand and the second hand with a simple structure.

According to the second and sixth aspects, the substrate can be transported between the load lock chamber and the processing chamber using the first hand and the second hand. Thus, the next substrate can be transported into the load lock chamber, and the load lock chamber can enter the vacuum state while the processing unit performs processing on the substrate. That is to say, pressure adjustment between the atmospheric pressure and the vacuum pressure for transporting the next substrate into the processing chamber can be completed until the processing is finished. Thus, the next substrate can be transported into the processing chamber in a shorter time after the substrate which has been processed is transported from the processing chamber.

According to the third aspect, a size of the transporter in the vertical direction can be reduced.

According to the fourth aspect, the substrate can be transported into and out of the processing chamber using each of the first hand and the second hand.

According to the fifth aspect, the first hand and the second hand can be used differently for the unprocessed substrate and the substrate which has been processed.

According to the seventh aspect, the unprocessed substrate is transported with the first hand located above the second hand, and the substrate which has been processed is transported with the second hand. Thus, even when an impurity adheres to the substrate by the processing and drops from the substrate during transportation, a possibility of adhesion of the impurity to the unprocessed substrate can be reduce by reason that the unprocessed substrate is supported by the first hand located above.

## Claims

1. A substrate processing apparatus, comprising:
a processing unit (30) including a processing chamber (31), a first support member (34) provided in the processing chamber (31) to support a substrate (W), and a first elevating driver (341) moving up and down the first support member (34), said processing unit performing processing on the substrate (W) in the processing chamber (31); and
a transporter (22) including an end effector (230) and a hand movement driver (24), the end effector (230) including a first hand (231), a second hand (232) provided below the first hand (231), and a connection member (233) connecting the first hand (231) and the second hand (232) to fix an interval between the first hand (231) and the second hand (232), the hand movement driver (24) moving the end effector (230) between a processing transfer position in the processing chamber (31) and an outside position of the processing chamber (31) along a horizontal direction, the first elevating driver (341) moving the first support member (34) to each of a first processing height position (H31), a second processing height position (H32), and a third processing height position (H33), the first processing height position (H31) being a position where a first direct contact part of the first support member (34) having contact with a lower surface of the substrate (W) is located above the first hand (231), the second processing height position (H32) being a position where the first direct contact part is located between the first hand (231) and the second hand (232), the third processing height position (H33) being a position where the first direct contact part is located below the second hand (232).

2. The substrate processing apparatus according to claim 1, further comprising
a load lock unit (10) including a load lock chamber (11) and switching the load lock chamber (11) between an atmospheric pressure state and a vacuum state, wherein
the transporter (22) is provided in a local transportation chamber (21),
the processing unit (30) performs processing on the substrate (W) in the processing chamber (31) in a vacuum state,
the transporter (22) transports the substrate (W) between the load lock chamber (11) and the processing chamber (31) in a vacuum state,
the load lock unit (10) further includes:
a second support member (13) provided in the load lock chamber (11) to support the lower surface of the substrate (W); and
a second elevating driver (14) moving up and down the second support member (13), and
the second elevating driver (14) moves the second support member (13) to each of a first load height position (H11), a second load height position (H12), and a third load height position (H13), the first load height position (H11) is a position where a second direct contact part of the second support member (13) having contact with the lower surface of the substrate (W) is located above the first hand (231), the second load height position (H12) is a position where the second direct contact part is located between the first hand (231) and the second hand (232), and the third load height position (H13) is a position where the second direct contact part is located below the second hand (232).

3. The substrate processing apparatus according to claim 1 or 2, wherein the hand movement driver (24) does not include an elevating driver moving up and down the end effector (230).

4. A method of controlling the substrate processing apparatus according to any one of claims 1 to 3, comprising:
making the transporter (22) move the end effector (230) to the processing transfer position and making the first elevating driver (341) move the first support member (34) between the first processing height position (H31) and the second processing height position (H32) or the third processing height position (H33) to transport the substrate (W) into or out of the processing chamber (31) with the first hand (231); and
making the transporter (22) move the end effector (230) to the processing transfer position and making the first elevating driver (341) move the first support member (34) between the second processing height position (H32) and the third processing height position (H33) to transport the substrate (W) into or out of the processing chamber (31) with the second hand (232).

5. The method of controlling the substrate processing apparatus according to claim 4, comprising:
transporting the substrate (W) into the processing chamber (31) with one of the first hand (231) and the second hand (232);
performing processing on the substrate (W) in the processing chamber (31); and
transporting the substrate (W) out of the processing chamber (31) with another one of the first hand (231) and the second hand (232).

6. A method of controlling the substrate processing apparatus according to claim 2, comprising:
transporting a first substrate (W1) into the processing chamber (31) with one of the first hand (231) and the second hand (232);
performing processing on the first substrate (W1) in the processing chamber (31);
transporting a second substrate (W2), which is supported by the second support member (13), into the load lock chamber (11) performed in parallel to at least a part of transporting the first substrate (W1) into the processing chamber (31) and performing the processing on the first substrate (W1);
reducing pressure in the load lock chamber (11) to within a vacuum range after supporting the second substrate (W2);
making the second substrate (W2) stand by at a second support member (13) or the first hand (231) until the processing on the first substrate (W1) is finished; and
transporting the first substrate (W1) from the processing chamber (31) into the local transportation chamber (21) with another one of the first hand (231) and the second hand (232) after reducing the pressure and performing the processing on the first substrate (W1).

7. The method of controlling the substrate processing apparatus according to claim 6, wherein
the first substrate (W1) is transported into the processing chamber (31) with the first hand (231) in transporting the first substrate (W1) into the processing chamber (31),
the second substrate (W2) is transported from the load lock chamber (11) into the local transportation chamber (21) with the first hand (231) in making the second substrate (W2) to stand by, and
the first substrate (W1) is transported out of the processing chamber (31) with the second hand (232) in transporting the first substrate (W1) from the processing chamber (31) into the local transportation chamber (21),
the method further comprising:
transporting the first substrate (W1) from the local transportation chamber (21) into the load lock chamber (11) with the second hand (232) after transporting the first substrate (W1) from the processing chamber (31) into the local transportation chamber (21); and
transporting the second substrate (W2) into the processing chamber (31) with the first hand (231) after transporting the first substrate (W1) from the local transportation chamber (21) into the load lock chamber (11) with the second hand (232).
